# EUROPEAN PATENT APPLICATION

(11) **EP 4 382 928 A1**
(43) Date of publication of application: **12.06.2024**
(21) Application number: 22212455.4
(22) Date of filing: 09.12.2022
(51) Int. Cl.: G01R 31/327, H02M 7/487

(54) **METHOD FOR DETECTING A STUCK AC SWITCH IN A CONVERTER**

(71) Applicant: ABB E-mobility B.V., 2629 JG Delft (NL)
(72) Inventor: MOTTA, Michele, 88047 Nocera Terinese (IT); RONDINE, Gianluca, 73048 Nardò (IT); PAOLINI, Simone, 52028 Terranuova Bracciolini (IT); BETTI, Giulio, 52048 Monte San Savino (IT); ROMANO, Martino, 52028 Terranuova B. NI. (IT); LEGA, Marco, 52021 Bucine (IT)
(74) Representative: Maiwald GmbH

(57) **Abstract**

The invention relates to the field of converters, e.g. DC/AC or AC/DC converters, and particularly to a method for detecting a stuck AC switch (Sₐ₁, S_{b1}, S_{c1}, Sₐₙ, S_{bn}, S_{cn}) in a converter with a plurality of converter arrangements (10.1, 10.n), arranged in parallel. Each of the converter arrangements (10.1, 10.n) is configured for connecting to a DC source or DC load (20), and to a plurality of AC terminals (30). Each converter arrangement (10.1, 10.n) comprises a DC part (14.1, 14.n), with two capacitors (Cₚ₁, Cₙ₁), arranged in parallel to the DC source or DC load (20), and a neutral DC point (O₁, Oₙ) between them. Further, each converter arrangement (10.1, 10.n) comprises a converter unit (12.1, 12.n) and at least one AC leg (a.1, b.1, c.1, a.n, b.n, c.n), each AC leg connected to a neutral AC point (N₁, Nₙ) via an AC leg capacitor (C_{fa1}, C_{fb1}, C_{fc1}, C_{fan}, C_{fbn}, C_{fcn}). A pre-charge unit (40), arranged at each leg of the AC terminal (30). Between the neutral DC point (O₁, Oₙ) and the neutral AC point (N₁, Nₙ), a decoupling switch (Sₒ₁, Sₒₙ) is arranged. The method comprising the steps of:
opening the second decoupling switch (Sₒₙ) and all second AC switches (Sₐₙ, S_{bn}, S_{cn}) of the second converter arrangement (10.n);
loading the pre-charge unit (40);
sequentially closing each second AC switch (Sₐₙ, S_{bn}, S_{cn}) of the second converter arrangement (10.n);
measuring, at each closing step, a voltage (V_{abn}, V_{bcn}, V_{can}) between each AC leg (a.n, b.n, c.n) of the second converter arrangement (10.n); and
determining the stuck AC switch (Sₐₙ, S_{bn}, S_{cn}) of the second converter arrangement (10.n) based on the measured voltage (V_{abn}, V_{bcn}, V_{can}).

## Description

### Field of the Invention

The invention relates to the field of converters, e.g. DC/AC or AC/DC converters, particularly to a method for detecting a stuck AC switch in a converter. The invention further relates to a converter arrangement, to a use, to a program element, and to a computer-readable storage medium.

### Background

In order to operate converters safely, checking a healthy status of the AC switches may be useful or necessary, before turning on the converter. For a converter with only a few lines and, thus, only a few AC switches, it may be possible to switch on and off each single AC switch for testing whether it functions. However, even for a small number of AC switches this may impose considerable effort for the service personnel; and for a high number of AC switches - e.g. in converter systems, where many power converters are arranged in parallel -, the effort may become prohibitive. However, using multiple power converters connected in parallel may be useful for building modular systems of high flexibility and/or for redundancy concepts.

### Description

It is an objective of the invention to provide an improved method for detecting a stuck AC switch, particularly in a converter that comprises a plurality of converter arrangements arranged in parallel. This objective is achieved by the subject-matter of the independent claims. Further embodiments are evident from the dependent claims and the following description.

One aspect relates to a method for detecting a stuck AC switch in a converter, the converter comprising a plurality of converter arrangements arranged in parallel. The converter arrangements are configured for connecting to a DC source or DC load, and configured for connecting to a plurality of AC terminals. Each converter arrangement comprises a DC part, comprising two capacitors, arranged in parallel to the DC source or DC load, and arranged in series to each other, having a neutral DC point between said capacitors; a converter unit, connected to the DC source or DC load and to an AC part, the AC part comprising at least one AC leg, each AC leg connected to a neutral AC point via an AC leg capacitor, and each AC leg connected to a respective leg of the AC terminal via an AC switch; a pre-charge unit, arranged at each leg of the AC terminal; and a decoupling switch, arranged between the neutral DC point and the neutral AC point. The method comprises the steps of:
Opening the second decoupling switch and all second AC switches of the second converter arrangement;
loading the pre-charge unit;
sequentially closing each second AC switch of the second converter arrangement; measuring, at each closing step, a voltage between each AC leg of the second converter arrangement; and
determining the stuck AC switch of the second converter arrangement based on the measured voltage.

A stuck AC switch is a switch that is continuously closed, i.e. continuously conductive. This may have been caused, at mechanical switches, by "gluing" the contacts of the switch, e.g. due to high current. This may have been caused, at electric switches, by a thermal damage. Other causes may apply as well. The AC switch may be arranged in a way to switch on and off a line of the converter arrangement that leads to the AC terminal. The converter comprises a plurality of converter arrangements, arranged in parallel. The converter may be designed as a DC/AC converter or as an AC/DC converter and/or as a bidirectional converter. In the following, some explanations may, for simplicity reasons, be mainly related to a DC/AC converter type (or, to a DC/AC converter arrangement, or to a DC/AC converter unit); however, these explanations may, analogously, also be applied to the other converter types.

Each converter arrangement is configured for connecting, on its DC side, to a DC source or DC load, and each converter arrangement is configured for connecting, on its AC side, to a plurality of AC terminals. The number of AC terminals of each converter arrangement may be dependent on the number of rails or legs the converter supports. For instance, for a converter that supports a three-phase power supply, each converter arrangement has three AC legs, each AC leg of the converter arrangement with a switch in the line leading to the converter's AC terminal. For the three-phase example, the converter's AC terminal may lead to loads eₐ, e_{b}, and e_{c} (or to sources, for the other converter types), for phases a, b, and c, respectively. For other numbers of AC rails, e.g. for one rail or AC leg, for two, three, four, five or more AC legs may have the respective number of AC switches in each converter arrangement. The loads eₐ, e_{b}, and e_{c} (or sources) may be connected to an electric grid, for instance to an MV (medium voltage) grid or to a low voltage grid.

Each converter arrangement comprises a DC part. The DC part, comprises two capacitors, arranged in parallel to the DC source or DC load, and arranged in series to each other. Thus, a neutral DC point is located between these capacitors. Each converter arrangement further comprises a converter unit (DC/AC, AC/DC, and/or bidirectional), connected to the DC source or DC load and to an AC part. The AC part comprises at least one AC leg (or two to five or more AC legs), each AC leg connected to a neutral AC point via an AC leg capacitor, and each AC leg connected to a respective leg of the AC terminal via the AC switch. The AC leg capacitor may be part of an LCL filter. The neutral AC point may also be called "star center" of the AC part or of the AC LCL filter. Each converter arrangement further comprises a decoupling switch, arranged between the neutral DC point and the neutral AC point.

The method may be performed before starting the converter and/or one or more of the converter arrangements. The method may, additionally or as an alternative, be performed as a part of a service routine. For the method, the second decoupling switch and all second AC switches of the second converter arrangement are opened. Then all first AC switches of the first converter arrangement are. After this, each second AC switch of the second converter arrangement is closed sequentially. A closing sequence for an exemplary converter with three AC legs is given below. At each closing step, a voltage between each AC leg of the second converter arrangement is measured. Based on the voltage measured this way, the stuck AC switch of the second converter arrangement can be determined. For instance, if no voltage is measured in any step, all the second AC switches of the second converter arrangement work properly. In case a voltage is measured in at least one step, an AC switch can be recognized as being stuck. The voltage may come (when the converter is operated as an AC/DC converter) from the AC source on the AC terminals. In other embodiments, the voltage may, e.g., come from a pre-charge unit that has been loaded before this checking sequence. The pre-charge unit may be not necessary, if the AC part delivers power, particularly if it delivers power continuously, and/or if the DC bus is already charged (e.g. at photovoltaic inverters).

Thus, the method checks the AC switches for a safe operation of the converter with very low additional costs and/or additional size of the converter. The healthy status of the AC switches may this way be checked before turning on the converter. A stuck AC switch can be detected at low effort, particularly in a converter that comprises a plurality of converter arrangements arranged in parallel. Furthermore, this method allows to perform the healthy check also while other parallel connected converters are turned on. Moreover, the decoupling switch allows the interruption of the circulation path for the homopolar current between the converters. Without the decoupling switch, when there are multiple converters connected in parallel, a standard healthy check cannot be applied, because this would introduce a homopolar current that may trigger the overcurrent protections in the converter arrangements that are already working. This would degrade the performance and/or the reliability of the complete converter system.

In various embodiments, the method further comprising the step of: Before loading the pre-charge unit, closing all first AC switches of the first converter arrangement. The pre-charge unit may only be used if the DC bus is not charged by any other source (e.g photovoltaic system) and before turning on the first converter. So, the switches of the first converter may be closed only once the first converter is ready to switch ON and if the DC bus voltage is charged.

In various embodiments, the method further comprising the step of: When opening the second decoupling switch of the second converter arrangement, opening decoupling switches of all converter arrangements. In detail, a proceeding may comprise following steps, e.g. in cases when all converters are off and if the converter operates as an AC/DC converter, i.e. if it takes energy from the AC grid: (1) Pre-charge the DC bus with the pre-charge unit. (2) First converter performs the algorithm as described above and/or below to look for stuck AC switches. (3) If there are not stuck AC switches, then converter 1 closes all the AC switches and starts to take power from the AC grid. Once there is voltage on the DC bus, power from the pre-charge unit may be unnecessary. Furthermore, the other converters may perform the algorithm as described above and/or below to find stuck contactors in the grid.

The i-th decoupling switch may be closed once the i-th converter is started. Each converter may control its own decoupling switches. The decoupling switch may be open once the converter is shut-down.

Generally, each converter may operate its own decoupling switch. During normal operation, the decoupling switch is open. It may be open when the converters check possible AC stuck switches. If there are not any stuck switches, the converter may close its own decoupling switch and may start to operate.

In various embodiments, the decoupling switches are kept open, if at least one of the AC switches of the related converter arrangement is found stuck. Generally, it is advantageous to switch off the decoupling switch, when the converter is not operating and/or during the healthy check. Assuming that one of the converter arrangements has diagnosed a stuck switch. Then, although the affected converter arrangement would be excluded from the operations, the performance of any other converter arrangement would be the system is seriously affected, without the decoupling switch. With the decoupling switch the problematic converter can advantageously be isolated.

In various embodiments, the AC switch and/or the decoupling switch is a mechanical switch, a relay, an IGBT (Insulated-Gate Bipolar Transistor), and/or a MOSFET (metal-oxide-semiconductor field-effect transistor). The selection of the switch type may be influenced by the voltage and/or the power that needs to be switched. In some embodiments, it may make sense to use a switch with mechanical and/or visible feedback. For some types of converters, a better feedback, e.g. for the service personnel, may thus be provided.

In some embodiments, the converter unit and/or the converter arrangement has one AC leg, two, three, four or five AC legs. Although embodiments with three AC legs may be quite common, there is no principal limit for the number of legs to implement in the converter. The method is basically suitable for a wide range of converter legs. In some embodiments, the converter unit is a T-type converter.

In various embodiments, the converter unit is designed as a DC/AC converter or as an AC/DC converter. In various embodiments, the converter unit is a bidirectional converter.

In some embodiments, the AC leg capacitor is part of an LCL filter. The LCL filter may comprise two inductors in series, between them the AC leg capacitor, which is connected to the neutral AC point. The LCL filter work as an improved low-pass filter, possibly additionally or as an alternative to a low-pass filter in the converter unit(s).

An aspect relates to a converter arrangement. The converter arrangement comprises a DC part, comprising two capacitors, arranged in parallel to the DC source or DC load, and arranged in series to each other, having a neutral DC point between said capacitors; a converter unit, connected to the DC source or DC load and to an AC part, the AC part comprising at least one AC leg, each AC leg connected to a neutral AC point via an AC leg capacitor, and each AC leg connected to a respective leg of the AC terminal via an AC switch; and a decoupling switch, arranged between the neutral DC point and the neutral AC point.

An aspect relates to a converter, comprising a plurality of converter arrangements, arranged in parallel and, optionally, a pre-charge unit as described above and/or below. The converter may be configured for voltages between 5 and 3000 V. The converter's voltage ranges and/or power ranges may depend on the voltage and/or power ranges the switches are specified for.

An aspect relates to a use of a converter arrangement and/or a converter for an MV (medium voltage) converter, UPS (uninterrupted power supply) systems, BESS (battery energy storage system), EV (electric vehicle) charging, a PV (photovoltaic) inverter, and/or further DC/AC converting systems. The method may presuppose a presence of a voltage on the AC side.

An aspect relates to a computer program product comprising instructions, which, when the program is executed by a control unit, cause the control unit to carry out the method as described above and/or below.

An aspect relates to a computer-readable storage medium where a computer program or a computer program product as described above is stored on.

It should be noted that two of more embodiments described above and/or below can be combined, as far as technically feasible.

For further clarification, the invention is described by means of embodiments shown in the figures. These embodiments are to be considered as examples only, but not as limiting.

### Brief Description of the Drawings

The drawings depict:
- **Fig. 1**: schematically a converter according to an embodiment;
- **Fig. 2a** and **2b**: schematically the converter of **Fig. 1** with current flows according to an embodiment;
- **Fig. 3**: schematically the converter of **Fig. 1** with other current flows according to an embodiment;

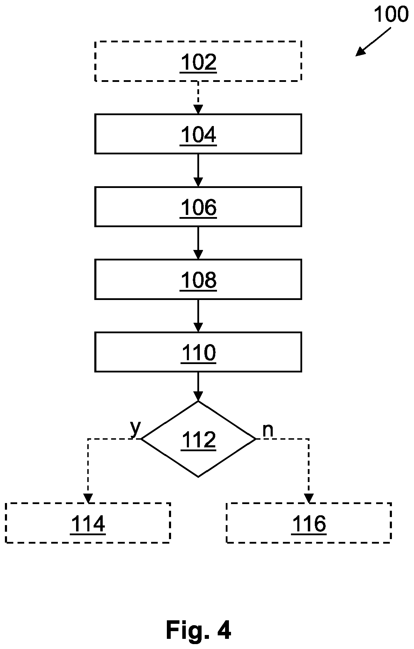

- **Fig. 4**: schematically a pre-charge unit according to an embodiment;
- **Fig. 5**: a flow diagram according to an embodiment.

### Detailed Description of Embodiments

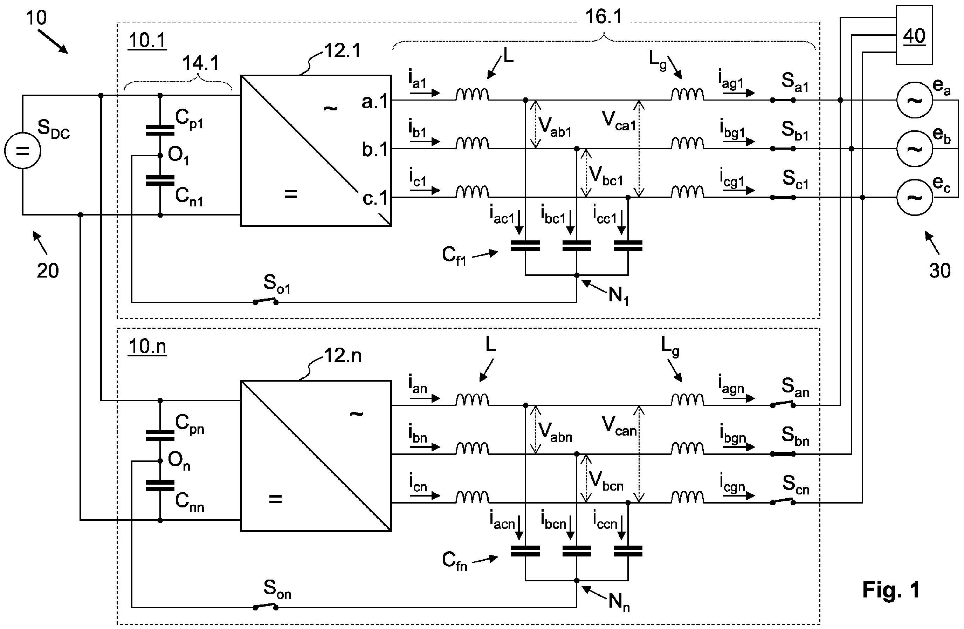

**Fig. 1** shows schematically a converter 10 according to an embodiment. The converter 10 comprises a plurality of converter arrangements 10.1, 10.n, arranged in parallel. The converter arrangements 10.1, 10.n are connected to a DC unit 20. If the converter 10 is run as a DC/AC converter (as shown), the DC unit 20 functions as a DC source S_{DC}. If the converter 10 is run as a AC/DC converter (not shown), the DC unit 20 functions as a DC load. The converter arrangements 10.1, 10.n are further connected to a plurality of AC terminals 30, comprising the elements eₐ, e_{b}, and e_{c}, for each AC leg a, b, and c, respectively. Each converter arrangement 10.1, 10.n comprises a DC part 14.1 and 14.n, respectively (for a better overview, only the reference sign for DC part 14.1 of converter arrangement 10.1 is depicted). The DC part 14.1 comprises two capacitors Cₚ₁, Cₙ₁, arranged in parallel to the DC unit 20. Between the capacitors Cₚ₁ and Cₙ₁, a neutral DC point O₁ is given. The DC part 14.n comprises, analogously, two capacitors Cₚ₁ and Cₙ₁, and a neutral DC point Oₙ. Furthermore, a converter unit 12.1, 12.n, connected to the DC unit 20 and to the AC part 16.1, 16.n is shown as part of converter arrangements 10.1 and 10.n, respectively.

Each converter arrangement 10.1, 10.n further comprises an AC part 16.1 and 16.n, respectively (for a better overview, only the reference sign for AC part 16.1 of converter arrangement 10.1 is depicted). The AC part 16.1, 16.n comprises, in this embodiment, three AC legs a.1, b.1, c.1 (of 16.1) and a.n, b.n, c.n (of 16.n). Each one of the AC legs is connected to a neutral AC point N₁, Nₙ via an AC leg capacitor C_{fa1}, C_{fb1}, C_{fc1}, C_{fan}, C_{fbn}, C_{fcn}. Also, each one of the AC legs is connected to a respective leg of the AC terminal 30 via AC switches Sₐ₁, S_{b1}, S_{c1} (of converter arrangement 10.1) and AC switches Sₐₙ, S_{bn}, S_{cn} (of converter arrangement 10.n). The switch S_{bn} is depicted as being stuck. Each converter arrangement 10.1, 10.n additionally comprises a decoupling switch Sₒ₁, Sₒₙ, arranged between the neutral DC point O₁, Oₙ and the neutral AC point N₁, Nₙ.

Fig. 5 shows a flow diagram according to an embodiment. In an optional step 102, a pre-charge unit 40 (see, e.g., **Fig. 1****)** is loaded. This step may be unnecessary, if AC elements eₐ, e_{b}, and e_{c} are an AC source. In a step 104, the second decoupling switch Sₒₙ and all second AC switches Sₐₙ, S_{bn}, S_{cn} of the second converter arrangement 10.n are opened. In a step 106, all first AC switches Sₐ₁, S_{b1}, S_{c1} of the first converter arrangement 10.1 are closed. In a step 108, each second AC switch Sₐₙ, S_{bn}, S_{cn} of the second converter arrangement 10.n is closed in a sequential way, i.e. for three AC switches Sₐₙ, S_{bn}, S_{cn}, in sub-steps 108(i), 108(ii), and 108(iii). In a step 110 (which may be parallel to step 108), at each closing step 108(i) to 108(iii), a voltage V_{abn}, V_{bcn}, V_{can} between each AC leg a.n, b.n, c.n of the second converter arrangement 10.n is measured. In a step 112, the stuck AC switch S_{bn} of the second converter arrangement 10.n is determined, based on the measured voltage V_{abn}, V_{bcn}, V_{can}. If at least one of the AC switches Sₐ₁, S_{b1}, S_{c1}, Sₐₙ, S_{bn}, S_{cn} of the related converter arrangement 10.1, 10.n is found stuck, in an optional step 114, the decoupling switches Sₒ₁, Sₒₙ are kept open. If all AC switches operate well, and/or during normal operation, the decoupling switches Sₒ₁, Sₒₙ are closed, in an optional step 116. The following table provides an additional survey over the steps, where switch S_{bn} is stuck:

| **Step** | **Sₐₙ** | **S_{bn}** | **S_{cn}** | **Sₒₙ** | **V_{abn}** | **V_{bcn}** | **V_{can}** |
|---|---|---|---|---|---|---|---|
| open all Sₙ | 0 | 0 | 0 | 0 | 0 | 0 | 0 |
| 108(i) & 110 | 1 | 0 | 0 | 0 | eₐ + e_{b} | 0 | 0 |
| 108(ii) & 110 | 0 | 1 | 0 | 0 | 0 | 0 | 0 |
| 108(iii) & 110 | 0 | 0 | 1 | 0 | 0 | e_{b} + e_{c} | 0 |
| 112 & 114 | 0 | 0 | 0 | 0 | 0 | 0 | 0 |

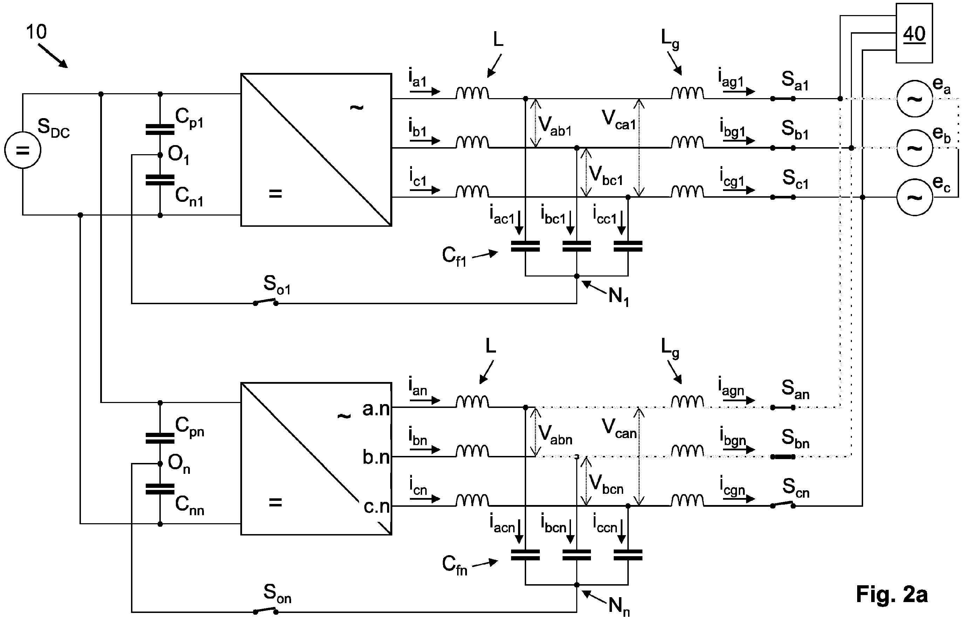

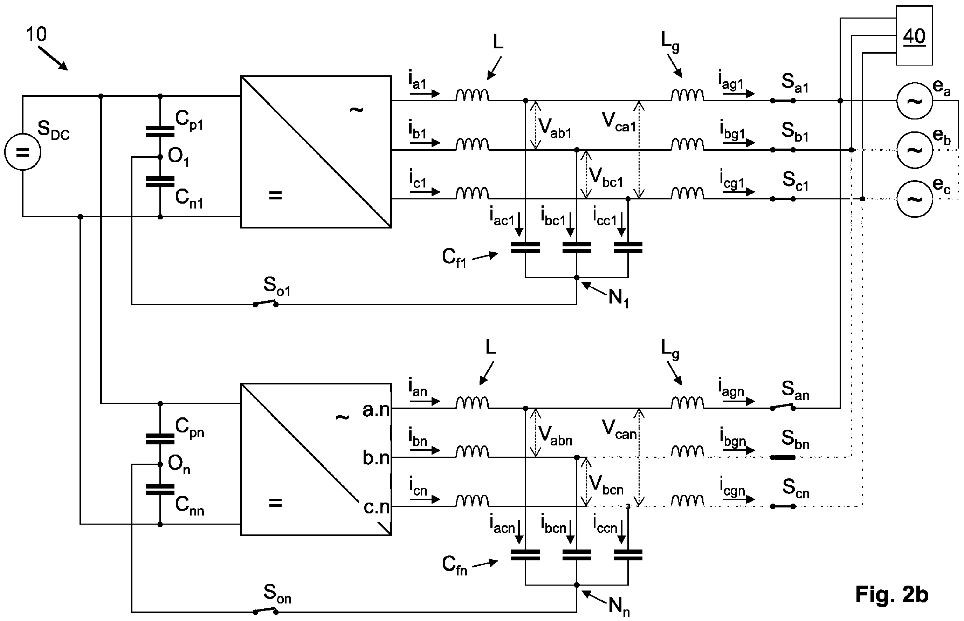

**Fig. 2a** and **Fig. 2b** show schematically the converter 10 of **Fig. 1** with current flows according to an embodiment. The switch S_{bn} is depicted as being stuck. In **Fig. 2a****,** currents of step 108(i) are shown. In step 108(i), AC switch Sₐₙ is closed (according to the method) and AC switch S_{bn} is stuck (because it is faulty). Thus, between legs a.n and b.n of the second converter arrangement 10.n a voltage V_{abn} = eₐ + e_{b} can be measured. In embodiments where eₐ, e_{b}, and e_{c} are loads, there may be still a voltage from the grid and, accordingly, the measured voltage is the grid. In cases when the grid is off, a voltage may come from the pre-charge unit. The measuring point for the voltages V_{abn}, V_{bcn}, V_{can} must, of course, be "behind" the AC switches Sₐₙ, S_{bn}, S_{cn}, seen from sources eₐ, e_{b}, and e_{c} or from the pre-charge unit 40, respectively.

In **Fig. 2b****,** currents of step 108(iii) are shown. In step 108(iii), AC switch S_{cn} is closed (according to the method) and AC switch S_{bn} is stuck (because it is faulty). Thus, a voltage V_{bcn} = e_{b} + e_{c} can be measured between legs b.n and c.n of the second converter arrangement 10.n. In embodiments, eₐ, e_{b}, and e_{c} may be the voltages on an electrical grid, independently if the grid is used as load or as source.

Note that in step 108(ii) no voltage can be measured, because AC switch S_{bn} is closed (stuck) and AC switches Sₐₙ and S_{cn} are open, because they work properly.

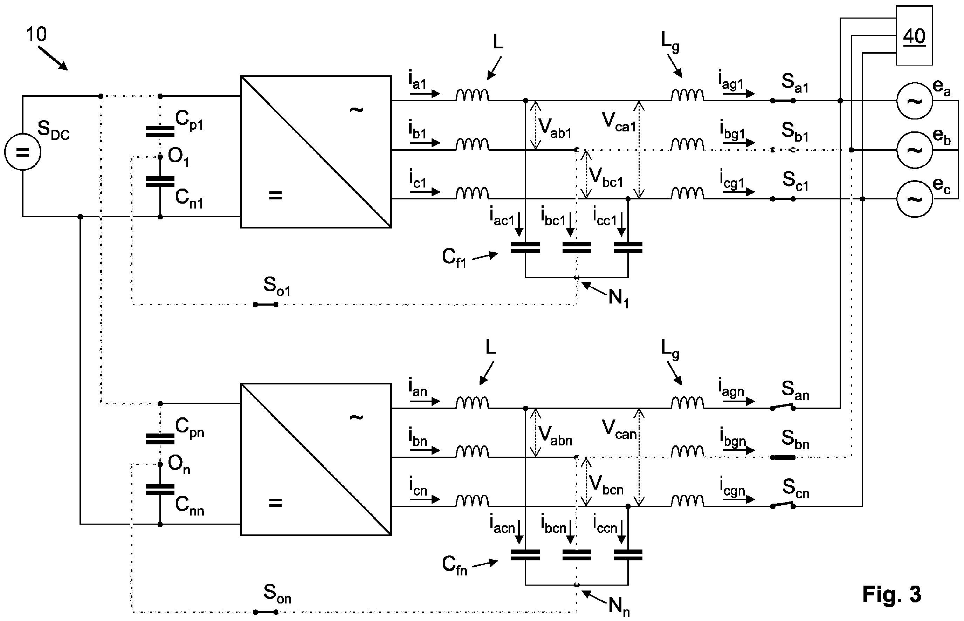

**Fig. 3** shows schematically the converter 10 of **Fig. 1** with other current flows according to an embodiment. The current flows depicted here can be measured when decoupling switches Sₒ₁ and Sₒₙ are closed, or if these switches Sₒ₁ and Sₒₙ are not available, as can be found in legacy converters. Without the decoupling switches Sₒ₁ and Sₒₙ (depicted here as closed decoupling switches Sₒ₁ and Sₒₙ) in the related converter arrangement 10.1, 10.n, the circulation path for a homopolar current between the converters cannot be interrupted. When a plurality of converter arrangements 10.1, 10.n are arranged in parallel, a path for the homopolar current is created. The effects of the homopolar current may comprise a deteriorated power quality and/or a worse condition that degrades the performance of the overall system. As shown in **Fig. 3****,** the faulty (stuck) AC switch S_{bn} leads to a current through the AC switch S_{b1} and S_{bn} and, further - because decoupling switches Sₒ₁ and Sₒₙ are not available - to currents between the neutral AC points N₁, Nₙ and the neutral DC point O₁, Oₙ, in the respective converter arrangement 10.1 and 10.n and, again further, through capacitors Cₚ₁ and Cₚₙ. An additional or alternative way may be via capacitors Cₙ₁ and Cₙₙ (not shown). It can clearly be seen that, although converter arrangement 10.n may have been excluded from operation, the performance of any other converter arrangement in the system may be affected seriously.

## Claims

1. A method for detecting a stuck AC switch (Sₐ₁, S_{b1}, S_{c1}, Sₐₙ, S_{bn}, S_{cn}) in a converter (10), the converter (10) comprising:
a plurality of converter arrangements (10.1, 10.n), arranged in parallel, configured for connecting to a DC source or DC load (20), and configured for connecting to a plurality of AC terminals (30),
each converter arrangement (10.1, 10.n) comprising:
a DC part (14.1, 14.n), comprising two capacitors (Cₚ₁, Cₙ₁), arranged in parallel to the DC source or DC load (20), and arranged in series to each other, having a neutral DC point (O₁, Oₙ) between said capacitors (Cₚ₁, Cₙ₁),
a converter unit (12.1, 12.n), connected to the DC source or DC load (20) and to an AC part (16.1, 16.n),
the AC part (16.1, 16.n) comprising at least one AC leg (a.1, b.1, c.1, a.n, b.n, c.n), each AC leg connected to a neutral AC point (N₁, Nₙ) via an AC leg capacitor (C_{fa1}, C_{fb1}, C_{fc1}, C_{fan}, C_{fbn}, C_{fcn}), and each AC leg connected to a respective leg of the AC terminal (30) via an AC switch (Sₐ₁, S_{b1}, S_{c1}, Sₐₙ, S_{bn}, S_{cn}),
a pre-charge unit (40), arranged at each leg of the AC terminal (30), and
a decoupling switch (Sₒ₁, Sₒₙ), arranged between the neutral DC point (O₁, Oₙ) and the neutral AC point (N₁, Nₙ),
the method comprising the steps of:
opening the second decoupling switch (Sₒₙ) and all second AC switches (Sₐₙ, S_{bn}, S_{cn}) of the second converter arrangement (10.n);
loading the pre-charge unit (40);
sequentially closing each second AC switch (Sₐₙ, S_{bn}, S_{cn}) of the second converter arrangement (10.n);
measuring, at each closing step, a voltage (V_{abn}, V_{bcn}, V_{can}) between each AC leg (a.n, b.n, c.n) of the second converter arrangement (10.n); and
determining the stuck AC switch (Sₐₙ, S_{bn}, S_{cn}) of the second converter arrangement (10.n) based on the measured voltage (V_{abn}, V_{bcn}, V_{can}).

2. The method of claim 1, the method further comprising the step of:
before loading the pre-charge unit (40), closing all first AC switches (Sₐ₁, S_{b1}, S_{c1}) of the first converter arrangement (10.1).

3. The method of claim 1 or 2, further comprising the step of:
when opening the second decoupling switch (Sₒₙ) of the second converter arrangement (10.n), opening decoupling switches (Sₒ₁, Sₒₙ) of all converter arrangements (10.1, 10.n).

4. The method of any one of the preceding claims,
wherein the decoupling switches (Sₒ₁, Sₒₙ) are kept open, if at least one of the AC switches (Sₐ₁, S_{b1}, S_{c1}, Sₐₙ, S_{bn}, S_{cn}) of the related converter arrangement (10.1, 10.n) is found stuck, and/or
wherein the decoupling switches (Sₒ₁, Sₒₙ) are closed during normal operation of the converter (10).

5. The method of any one of the preceding claims,
wherein the AC switch (Sₐ₁, S_{b1}, S_{c1}, Sₐₙ, S_{bn}, S_{cn}) and/or the decoupling switch (Sₒ₁, Sₒₙ) is a mechanical switch, a relay, an IGBT, and/or a MOSFET.

6. The method of any one of the preceding claims,
wherein the converter unit (12.1, 12.n) and/or the converter arrangement (10.1, 10.n) has one AC leg, two, three, four or five AC legs, and/or
the converter unit (12.1, 12.n) is a T-type converter.

7. The method of any one of the preceding claims,
wherein the converter unit (12.1, 12.n) is designed as a DC/AC converter or as an AC/DC converter.

8. The method of any one of the preceding claims,
wherein the converter unit (12.1, 12.n) is a bidirectional converter.

9. The method of any one of the preceding claims,
wherein the AC leg capacitor (C_{fa1}, C_{fb1}, C_{fc1}, C_{fan}, C_{fbn}, C_{fcn}) is part of an LCL filter.

10. A converter arrangement (10.1, 10.n) comprising:
a DC part (14.1, 14.n), comprising two capacitors (Cₚ₁, Cₙ₁), arranged in parallel to the DC source or DC load (20), and arranged in series to each other, having a neutral DC point (O₁, Oₙ) between said capacitors (Cₚ₁, Cₙ₁),
a converter unit (12.1, 12.n), connected to the DC source or DC load (20) and to an AC part (16.1, 16.n),
the AC part (16.1, 16.n) comprising at least one AC leg (a.1, b.1, c.1, a.n, b.n, c.n), each AC leg connected to a neutral AC point (N₁, Nₙ) via an AC leg capacitor (C_{fa1}, C_{fb1}, C_{fc1}, C_{fan}, C_{fbn}, C_{fcn}), and each AC leg connected to a respective leg of the AC terminal (30) via an AC switch (Sₐ₁, S_{b1}, S_{c1}, Sₐₙ, S_{bn}, S_{cn}), and
a decoupling switch (Sₒ₁, Sₒₙ), arranged between the neutral DC point (O₁, Oₙ) and the neutral AC point (N₁, Nₙ).

11. A converter (10), comprising a plurality of converter arrangements (10.1, 10.n) according to claim 10, arranged in parallel and, optionally, a pre-charge unit (40).

12. Use of a converter arrangement (10.1, 10.n) and/or a converter (10) for an MV (medium voltage) converter, UPS (uninterrupted power supply) systems, BESS (battery energy storage system), EV (electric vehicle) charging, a PV (photovoltaic) inverter, and/or further DC/AC converting systems.

13. A computer program product comprising instructions, which, when is executed by a control unit, cause the control unit to carry out the method according to any one of the claims 1 - 9.

14. A computer-readable storage medium on which the computer program according to claim 13 is stored.
